# EUROPEAN PATENT SPECIFICATION

(11) **EP 4 139 968 B1**
(45) Date of publication and mention of the grant of the patent: **01.05.2024**
(21) Application number: 21737010.5
(22) Date of filing: 23.06.2021
(51) Int. Cl.: H01L 31/048, H02S 20/00

(54) **METHOD FOR FABRICATING A CURVED PHOTOVOLTAIC MODULE INCLUDING ADAPTED POSITIONING OF PHOTOVOLTAIC CELLS**
VERFAHREN ZUR HERSTELLUNG EINES GEKRÜMMTEN FOTOVOLTAISCHEN MODULS MIT ANGEPASSTER POSITIONIERUNG VON FOTOVOLTAISCHEN ZELLEN
PROCÉDÉ DE FABRICATION D'UN MODULE PHOTOVOLTAÏQUE INCURVÉ COMPRENANT UN POSITIONNEMENT ADAPTÉ DE CELLULES PHOTOVOLTAÏQUES

(30) Priority: 24.06.2020 GB 202009653
(43) Date of publication of application: 01.03.2023
(73) Proprietor: Sono Motors GmbH, 80935 München (DE)
(72) Inventor: BAUDRIT, Mathieu, 80636 Munich (DE)
(74) Representative: Qip Patentanwälte Dr. Kuehn & Partner mbB
(86) International application number: PCT/EP2021/067184
(87) International publication number: WO 2021/260024

(56) References cited:
- CH-A5- 683 730
- CN-A- 108 984 915
- DE-A1-102004 003 328
- US-A1- 2013 000 701
- US-A1- 2020 144 431

## Description

### FIELD OF THE INVENTION

The present invention relates to a method for fabricating a photovoltaic module.

### BACKGROUND OF THE INVENTION

Photovoltaic modules comprise photovoltaic cells which may convert light energy into electric energy based on photovoltaic effects. Today, most commercial photovoltaic modules include photovoltaic cells which are manufactured based on semiconductor wafers such as silicon wafers. Wafer-based photovoltaic cells may be made with high conversion efficiencies at low costs. Furthermore, wafer-based photovoltaic cells may be manufactured using reliable industrial manufacturing processes.

In the following, the term "photovoltaic" may be abbreviated by "PV". PV cells are also referred to as solar cells.

Conventionally, a PV module comprises a stack of several sheets and layers. Typically, a solar cell arrangement including a plurality of PV cells and electrical connections interconnecting the PV cells is interposed between a front side polymeric foil and a rear side polymeric foil. As such foils are generally thin and therefore highly bendable, the foils alone may not provide a sufficiently stable and rigid bases for the PV module. Therefore, additionally to the foils, the PV module further comprises a carrier structure.

Conventionally, such carrier structure is provided by one or more rigid sheets. For example, a front side sheet, i.e. a sheet at a front side of the PV module to be directed towards incident light, may be made with a transparent glass plate. Such front side sheet may cover, protect and stabilise the PV cells. Additionally or alternatively, the carrier structure may comprise a rear side sheet formed for example by a glass plate or a metal sheet.

In fabricating a conventional PV module, the stack of one or more rigid sheets, the solar cell arrangement and the front and rear side polymeric foils is prepared. Therein, the solar cell arrangement is interposed between the front and rear side polymeric foils, thereby forming a sub-stack. This sub-stack is placed on one rigid sheet or between two rigid sheets, thereby forming the entire stack. Subsequently, the entire stack is heated to an elevated temperature. At such elevated temperature, the material of the polymeric foils liquefies or at least comes to a viscous state such that the front side polymeric foil and the rear side polymeric foil are laminated to form a tight stack with the solar cell arrangement being comprised in between the two foils and, furthermore, the polymeric foils being joined with the one or more rigid sheets. Finally, a frame is typically arranged around the laminated entire stack. The frame provides additional mechanical stability and furthermore may serve for installing the PV module for example on top of a roof or on a pillar.

While such conventional fabricating of PV modules is well established, it may suffer from various deficiencies.

For example, laminating the solar cell arrangement to a carrier structure of one or more rigid sheets conventionally requires that the rigid sheets are planar. Accordingly, the entire PV module has a planar shape. However, there are various applications in which a PV module having a non-planar shape may be beneficial. For example, it has been proposed e.g. in an earlier patent application WO 2019/020718 A1 of the present applicant to integrate solar cells into a body part of a vehicle. Therein, the body part may have a non-planar, i.e. curved, shape and the PV module shall be placed on top of such body part or, preferably, the PV module shall be integrated into the body part or integrally forms the body part.

Furthermore, providing the PV module with a carrier structure formed for example by a glass sheet and/or a metal sheet may add substantial weight to the PV module and/or may add substantial costs for providing the glass sheet and/or metal sheet.

In order to overcome at least some of the above mentioned deficiencies, a new approach for manufacturing PV modules has been proposed by the present applicant in an earlier patent application WO 2020/187792 A1. Therein, a solar cell arrangement joined with a polymeric foil is integrated with a moulded layer formed by injection moulding. The moulded layer together with the integrated solar cell arrangement may form a PV module having a non-planar shape and may be manufactured at low costs. Features and characteristics of such approach may also apply to the method described herein.

US 2013/0000701 A1 discloses another example of a curved module containing PV cells.

However, it has been observed that, upon fabricating curved PV modules, care has to be taken in order to avoid deficiencies resulting for example in a non-optimum conversion efficiency of the PV module and/or a decreased longevity of the PV module.

Accordingly, it may be an object to enable fabricating a PV module and overcome at least some of the above mentioned deficiencies. Particularly, it may be an object to enable fabricating a PV module, in particular a PV module with a non-planar shape, with high module efficiency, high reliability, high throughput, low costs and/or a high quality of the final PV module.

### SUMMARY OF THE INVENTION AND OF EMBODIMENTS

At least some of these objects may be achieved with a method as defined in the independent claim. Preferred embodiments are defined in the dependent claims as well as in the subsequent specification.

According to an aspect of the invention, a method for fabricating a non-uniformly curved photovoltaic module comprising multiple photovoltaic cells is proposed. The method at least comprises the following method steps, preferably, but not necessarily, in the indicated order:
- determining a minimum allowable bending radius of the photovoltaic cells,
- analysing a curvature radius of one of the photovoltaic cells being assumed to being arranged at a positioning area within the photovoltaic module, wherein the curvature radius is analysed for each of multiple positioning areas along a lateral extension of the photovoltaic module,
- arranging the photovoltaic cells in a curvature limited configuration in which none of the photovoltaic cells overlaps a highly bended area the curvature radius of which has been analysed to be smaller than the minimum allowable bending radius for the photovoltaic cell, and
- fixing the photovoltaic cells in the curvature limited configuration within the photovoltaic module.

Ideas underlying embodiments of the present invention may be interpreted as being based, inter alia and without restricting a scope of the invention, on the following observations and recognitions.

First, some basic ideas underlying embodiments of the present invention may be briefly summarised as follows:
Wafer-based solar cells such as solar cells made from monocrystalline, multicrystalline or polycrystalline silicon wafers are applied today in most PV modules due to their high-efficiency and low-cost fabrication. However, such wafer-based solar cells are known to be generally rigid and very brittle. Accordingly, it has generally been assumed that wafer-based solar cells shall not be substantially curved or bent upon being encapsulated into a PV module. Therefore, wafer-based solar cells are conventionally included in rigid and planar PV modules in which a rigid front glass sheet and/or a rigid rear sheet protect the solar cells from being excessively bent. However, it has been found by the applicant that even rigid and brittle solar cells may be arranged in a curved PV module as long as specific measures are taken. Particularly, it has been found that upon, on the one side, determining an allowable bending radius in which the solar cells may be bent without breaking or cracking and, on the other side, analysing the curvature radius at which each solar cell would have to be bent upon being arranged at one of multiple areas within the PV module, a suitable configuration of the solar cells' locations within the PV module may be determined such that none of the solar cells is excessively bent. Accordingly, in such approach, solar cells may be suitably arranged within a non-uniformly curved PV module.

Next, details, features and possible advantages of embodiments of the proposed method for fabricating the PV module will be discussed:
The approach proposed herein is particularly suitable for fabricating PV modules comprising multiple PV cells which are prepared based on brittle semiconductor wafers. The PV cells may be for example solar cells being fabricated based on crystalline silicon wafers. Such wafer-based Si-PV cells may generally have e.g. a high efficiency of more than 15% (i.e. e.g. between 17% and 24%) and a high reliability. Furthermore, well established industrial processes exist for their fabrication. Such PV cells typically have lateral dimensions of between 50×50 mm² and 300×300 mm², mostly between 150×150 mm² and 200×200 mm², with a square shape, a rectangular shape, a round shape, a semi-round shape or any other shape. Furthermore, such PV cells generally have a thickness of more than 50 µm, typically between 100 µm and 300 µm. Having such thickness, the PV cells are relatively rigid, i.e. they may generally not be bent into small bending radii of e.g. less than their lateral dimensions. Each PV cell comprises electric contacts. The electric contacts of neighbouring PV cells may be interconnected via electrical connections such that these PV cells may be electrically connected in series, in parallel or any combination of series and parallel connections. The electrical connections may be provided by one or more electrically conducting ribbons and/or one or more copper soldering between two adjacent photovoltaic cells, preferably between each two adjacent photovoltaic cells of a respective string. A plurality of interconnected PV cells forms a solar cell arrangement, sometimes also referred to as solar cell string. The solar cell arrangement may further comprise additional components such as external contacts via which the solar cell arrangement may be connected to an external electric circuit, such external contacts sometimes being often referred to as forming part of a junction box. Furthermore, the solar cell arrangement may comprise for example bypass diodes or other electric components. Additionally, one or more release loops for releasing mechanical tensions may be included in the solar cell arrangement.

In the method proposed herein, multiple PV cells shall be included in a non-uniformly curved PV module. Therein, as the PV module is not planar but has a curved shape and curvature radii vary along the PV module, a configuration in which the PV cells are arranged shall be suitably determined such as to avoid damages to the PV cells.

For example, the proposed method may be applied for fabricating curved PV modules in which the curvature radius differs in various areas of the PV module by more than 50%, preferably more than a factor of 2, 5, 10 or even 100. In other words, the PV module may have areas which are substantially planar or only slightly curved and other areas which are substantially curved and which, in cases of very small curvature radii, are referred to hereinafter also as highly bended areas. In the substantially planar or only slightly curved areas, a curvature radius may be more than 0.5 m, more than 1 m or even more than 3m. In the substantially curved areas, the curvature radius may be less than for example half of the curvature radius in the planar or slightly curved areas, i.e. less than 1.5 m, less than 0.5 m or less than 25 cm, respectively. Each of the planar or slightly curved areas, on the one hand, and the substantially curved areas, on the other hand, may contribute more than 5%, preferably more than 10% or even more than 20% to an overall area of the PV module. Preferably, one or more substantially curved areas may be surrounded by one or more planner slightly curved areas.

In such in homogeneously curved PV modules, the PV cells should be arranged in a suitable configuration.

In order to determine such suitable configuration, acquiring two types of information is required.

On the one hand, it has to be determined down to which bending radius the photovoltaic cells may be bent before suffering from breakage or other irreversible deteriorations due to excessive bending. Such minimum allowable bending radius may have to be determined for each of the PV cells or, if all PV cells of the PV module are of an identical type, for the type of PV cell.

On the other hand, it has to be determined to which curvature radius a PV cell would have to be bent in case the PV cell would be positioned at a specific area within the PV module. Such location-dependent curvature radius of the PV cells should be determined for each of multiple possible areas along the lateral extension of the PV module.

The step of determining the minimum allowable bending radius of the PV cells and that the step of analysing the curvature radius of the PV cells upon being arranged at various positioning areas in the PV module may be executed before or upon fabricating the PV module in any arbitrary order or even simultaneously.

Having determined both these information data, each of the PV cells may then be positioned within the PV module in a configuration in which it does not overlap a highly bended area of the PV module, as the previous analysis indicates that upon being arranged at such highly bended area, the PV cell would have to be bent excessively, i.e. with a curvature radius becoming smaller than the minimum allowable bending radius. Such configuration is referred to herein as curvature limited configuration.

Finally, the PV cells are fixed within the PV module in such curvature limited configuration. As explained in further detail below, the arranging and/or fixing of the PV cells may be part of a fabrication procedure in which the PV cells are first attached to a polymeric foil or encapsulated between two polymeric foils and the so-called PV label generated thereby is then provided with a carrier structure for example by injection moulding, such combined procedure possibly being part of a fabrication method being similar to a technique known as in-mould labelling (IML).

The curvature radius of a plate-like solar cell is inverse to the bending applied to the solar cell, i.e. the more the solar cell is forced to bend away from its originally planar shape, the smaller is the curvature radius. The minimum allowable curvature radius is the curvature radius up to which the PV cell may be bent without irreversibly breaking or cracking. Generally, the minimum allowable curvature radius of a PV cell may depend on various physical parameters such as a material of the PV cell, a thickness of the PV cell, a surface texture of the PV cell, a crystal structure of the material of the PV cell, a structure and geometry of metal contacts on top of a wafer of the PV cell, etc.

In the step of determining the minimum allowable bending radius, the minimum allowable bending radius of the PV cell may be determined by bending experiments, bending simulations and/or bending calculations. The experiments, simulations or calculations may be performed for measuring, simulating or calculating, respectively, the curvature radius of the PV cell upon being successively bent, the minimum allowable bending radius being determined as the curvature radius being established just before the photovoltaic cell breaks due to excessive bending.

In other words, the minimum allowable curvature radius may be determined in various ways. For example, a real PV cell may be bent by applying forces to the PV cell in bending experiments. The forces may be applied for example in a direction orthogonal to a main surface of the PV cell. Preferably, the forces are applied homogeneously along the surface of the PV cells such that no excessive peak forces are induced locally. In a bending experiment, the curvature radius may be successively measured such as to determine a minimum curvature radius just before the PV cell breaks. Alternatively or additionally, bending characteristics of the PV cell may be determined in bending simulations. Such simulations may be executed on a computer and may be performed based on computer models taking into account typical physical characteristics of the PV cells such as its dimensions, material characteristics, etc. For example, bending simulations may be established based on an FEM (finite element model) of the PV cell. In such simulations, a reaction of the PV cell to applied forces may be simulated. As another alternative or additional measure, bending characteristics of the PV cell may be determined by analytical and/or numerical calculations, again taking into account typical physical characteristics of the PV cells.

The actual curvature radius of the PV cells upon being included in the PV module may differ from cell to cell and may typically depend on a shape of the non-uniformly curved PV module and a position of the respective PV cell within such PV module. Particularly, in areas where the PV module is curved more than in other areas, the PV cells arranged at such areas have to be bent into a smaller curvature radius than in the other areas.

Particularly, it may be intended to provide the PV module as being attached to or being an integral part of a component such as a vehicle body part, such component having a surface with areas, where the surface's curvature radius is rather large (i.e. the surface is almost planar), whereas in other areas, the surface's curvature radius is rather small (i.e. the surface is strongly bent). As the PV cells in a PV module are typically arranged at or close to the surface of the PV module, the PV cells themselves are generally curved to a degree which largely corresponds to the curvature of the PV module.

According to an embodiment, the curvature radius may be analysed for one of the PV cells being assumed to being arranged at the positioning area within the photovoltaic module upon the photovoltaic module being in its final geometry after completion of the fabrication method.

In other words, in the step of analysing the curvature radii of the PV cells at various positioning areas throughout the PV module, it is assumed that the PV module is in its final geometry. Typically, during fabrication of the PV module, its geometry may temporarily deviate from an intended final geometry for example due to forces being applied during a fabrication process. However, upon completion of the fabrication process, the PV module gets into its intended final geometry. The curvature radii of the PV cells may be analysed with respect to such final geometry.

Particularly, the curvature radius of the photovoltaic cell may be analysed by arrangement experiments, arrangement simulations and arrangement calculations performed for one of measuring, simulating and calculating, respectively, the curvature radius of the photovoltaic cell when being arranged at the positioning area.

Expressed differently, based on an information about the final geometry of the PV module and particularly based on an information about a local curvature radius at various locations along the surface of the PV module in its intended final geometry, a PV cell may be arranged at various positioning areas along the PV module and the resulting curvature radius of the PV cell may be determined. Particularly, the PV cell may be arranged at positioning areas in an arrangement experiment, i.e. by arranging the real PV cell for example at a location within a prototype PV module, and the curvature radius assumed by the PV cell may be measured. Alternatively or additionally, the PV cell may be arranged at positioning areas in an arrangement simulation, i.e. by locating a virtual PV cell within a computer model of a PV module, and the curvature radius assumed by the PV cell may be obtained from data provided by such arrangement simulation. As a further alternative or additional measure, data about a geometry of the PV module may be used in arrangement calculations for analytically and/or numerically calculating the curvature radius of a PV cell upon being arranged at a specific positioning area.

According to a further embodiment, the curvature radius may be analysed for one of the photovoltaic cells being assumed to being arranged at the positioning area within the photovoltaic module upon the photovoltaic module being deformed into a first temporary geometry during the fabrication method.

In other words, upon analysing the curvature radii of the PV cells in the PV module, it may be taken into account that the PV module may temporarily be deformed during a fabrication procedure. For example, upon fabricating a PV module using an injection moulding procedure or, more specifically, an in-mould labelling procedure, a geometry of an intermediate product may differ from the final geometry of the PV module. Such differing geometry is referred to herein as first temporary geometry. Specifically, the geometry of the intermediate product may be bent to a higher degree due to e.g. forces being applied to the intermediate product during the fabrication procedure and may subsequently relax to a geometry which is bent to a lower degree, i.e. comprising larger curvature radii.

By analysing the curvature radius of the PV cells with regard to the PV module being deformed into its first temporary geometry during the fabrication method, it may be taken into account that the PV cells may be temporarily bent locally into smaller curvature radii during the fabrication of the PV module in comparison to the curvature radii in the PV module after completion of the fabrication. Accordingly, the arranging of the PV cells in the curvature limited configuration may be adapted such that none of the PV cells overlaps a highly bended area in which the curvature radius is smaller than the minimum allowable bending radius of the PV cell, this being true not only in the final PV module but also during fabrication of this PV module.

Particularly, in such embodiment, the curvature radius of the photovoltaic cell may be analysed by deformation experiments, deformation simulations and/or deformation calculations performed for one of measuring, simulating and calculating, respectively, the curvature radius of the photovoltaic cell when being arranged at the positioning area upon the photovoltaic cell being subjected to a deformation action, the deformation action occurring as a result of a fabrication procedure and temporarily deforming the curvature of the photovoltaic cell during the fabrication method.

Expressed differently, experiments, simulations and/or calculations may be performed for obtaining additional information about how the curvature radius of the photovoltaic cells may be influenced due to the deformation actions temporarily occurring during procedures for fabricating the PV module. This additional information may be taken into account upon analysing the curvature radii of the PV cells in the PV module and, finally, upon arranging the PV cells in the curvature limited configuration. The deformation experiments, simulations and/or calculations may be performed in a same or similar manner as described further above for the arrangement experiments, simulations and calculations.

According to a further embodiment, the curvature radius may be analysed for one of the PV cells being assumed to being arranged at the positioning area within the photovoltaic module upon the photovoltaic module being deformed into a second geometry resulting upon thermal expansion of the photovoltaic module upon the fabricated photovoltaic module being installed in an intended installation configuration and being subjected to predefined temperature variations.

In other words, upon analysing the curvature radii of the PV cells in the PV module, it may be taken into account that the PV module may be deformed upon being installed in its final installation configuration. For example, the PV module, having a final geometry upon completion of its fabrication, may then be installed at a support structure. Specifically, the PV module being established as forming a body part of a vehicle or being integrated into such body part may for example be installed at a chassis of the vehicle such as to form a part of a car body of the vehicle. In such installation, the PV module is typically fixed at the support structure at various locations while being lose in areas between such fixation locations. Accordingly, upon the PV module changing its dimensions due to differing thermal expansions upon being subjected to temperature variations, the PV module will change its shape. The resulting geometry of the PV module is referred to herein as second geometry. As a result, curvature radii in different areas of the PV module will vary in reaction to the temperature variations.

By analysing the curvature radius of the PV cells with regard to the PV module being deformed into its second temporary geometry upon being installed in an intended installation configuration, it may be taken into account that the PV cells may be temporarily bent into a smaller curvature radius as a result of the PV module being bent into a different geometry due to thermal expansion effects in comparison to the curvature radius of the PV module after completion of the fabrication. Accordingly, the arranging of the PV cells in the curvature limited configuration may be adapted such that none of the PV cells overlaps a highly bended area in which the curvature radius is smaller than the minimum allowable bending radius of the PV cell, this being true not only in the final PV module but also upon the PV module being finally installed and being subjected to temperature variations within a predefined temperature range.

Particularly, in such embodiment, the curvature radius of the photovoltaic cell may be analysed by at least one of expansion experiments, expansion simulations and expansion calculations performed for one of measuring, simulating and calculating, respectively, the curvature radius of the photovoltaic cell when being arranged at the positioning area upon the photovoltaic module being subjected to thermal expansion upon the fabricated photovoltaic module being installed in the intended installation configuration and being subjected to predefined temperature variations.

Expressed differently, experiments, simulations and/or calculations may be performed for obtaining additional information about how the curvature radius of the PV cells may be influenced due to forces acting upon the PV module when installed in its final installation configuration and being subjected to temperature variations. For example, in expansion experiments, the PV module may be installed at a carrier structure and may then be heated and/or cooled throughout an intended temperature range. The deformations of the installed PV module resulting from the induced thermal expansions may then be measured. Alternatively or additionally, a virtual model of the PV module may be virtually installed at installation positions and may be virtually subjected to temperature variations. Therein, thermal expansion characteristics of the PV module may be taken into account and information about a resulting the deformation or a resulting second geometry of the PV module at various simulated temperatures may be derived. As a further alternative or addition, thermal expansion effects on the PV module may be calculated analytically and/or numerically. The additional information derived from such expansion experiments, simulations and/or calculations may be taken into account upon analysing the curvature radii of the PV cells in the PV module and, finally, upon arranging the PV cells in the curvature limited configuration.

According to an embodiment, in the step of arranging the PV cells in the curvature limited configuration, the photovoltaic cells may be arranged on both opposite sides with regard to the highly bended area.

In other words, in a configuration of the PV module in which the highly bended area is not located at or close to an outer circumference of the PV module but somewhere within the PV module, the fabrication method proposed herein allows for arranging PV cells adjacent to such highly bended area on both sides of the highly bended area. For example, when the highly bended area is arranged at or close to a centre of the PV module, PV cells may be arranged on the right side and on the left side and/or on an upper side and on a lower side with regard to the highly bended area while none of these PV cells being arranged in the highly bended area or overlapping the highly bended area. Accordingly, an available area of the non-uniformly curved PV module may be covered with PV cells to a maximum extend without, however, arranging PV cells at the highly bended area where a risk of cracking or breaking the PV cells would be high. Accordingly, a conversion efficiency of the non-uniformly curved PV module may be maximised.

According to an embodiment, the photovoltaic cells may be arranged at a lateral distance from the highly bended area, the lateral distance being larger than a predefined minimum distance.

In other words, while the highly bended area, at which the curvature of a PV cell arranged in such area would exceed an acceptable curvature, should always be free from any PV cell or part of a PV cell, it may be advantageous to not arranging PV cells in an additional lateral tolerance distance range around such highly bended area. For example, upon arranging the PV cells in the curvature limited configuration, none of the PV cells should come closer to the highly bended area by less than for example a few millimetres or even a few centimetres. Specifically, the lateral distance between the outer circumference of the highly bended area, on the one hand, and the circumference of PV cells coming closest to the highly bended area, on the other hand, may be selected to being larger than the predefined minimum distance of for example at least 2 mm, preferably at least 5 mm, at least 1 cm or at least 5 cm.. By establishing such lateral distance or tolerance, a risk of PV cells being broken or cracked due to being excessively bent during fabrication and/or upon thermal expansion effects after installation may be further reduced.

Particularly, in such embodiment, the minimum distance may be predefined in dependence of the curvature radius at the highly bended area. This means that, for example, the smaller the curvature radius in the highly bended area is, the larger the minimum distance at which the PV cells coming closest to the highly bended area are arranged may be selected. Such defining the minimum distance of PV cells from the highly bended area may further reduce the risk of cracks or breakage.

According to a further specified embodiment, the arranging and fixing of the photovoltaic cells include further steps of:
- arranging the photovoltaic cells on at least one polymeric foil in the curvature limited configuration,
- fixing the photovoltaic cells on the polymeric foil in the curvature limited configuration thereby forming a photovoltaic label, and
- preparing a carrier structure for carrying the photovoltaic label, wherein the carrier structure is prepared with a polymer being in a mouldable condition such that the polymer forms a positive substance jointing with the polymeric foil upon solidifying of the polymer.

In other words, the proposed method for fabricating the non-uniformly curved PV module may comprise fabrication steps being similar to those applied in injection moulding procedures or, more specifically, in in-mould labelling (IML) procedures. Therein, a PV label is generated by arranging and fixing PV cells on at least one polymeric foil or, preferably, between two polymeric foils. Specifically, the PV cells are arranged and fixed to the polymeric foil in the curvature limited configuration. Therein, the PV cells may be electrically interconnected with each other. As the polymeric foil(s) are thin and flexible, the PV label is generally not self-supporting. Accordingly, in order to provide the PV module with sufficient mechanical stability, an additional carrier structure is prepared for carrying the PV label. Therein, similar to injection moulding procedures, a polymer is provided in a mouldable condition, i.e. in a condition where it is viscous and "sticky". For example, the polymer may be heated to an elevated temperature in order to become mouldable. The mouldable polymer may be applied to the PV label such as to form a positive substance jointing with the polymeric foil of the PV label upon subsequent cooling down of the polymer. As a result of such procedure, a PV module may be fabricated in which the carrier structure as well as the PV label are provided with a non-uniformly curved shape and in which the PV cells are included in the PV label in the curvature limited configuration such that excessively bending of PV cells may be prevented.

In the following, some possible features and characteristics of such IML-like procedure will be described. However, such features and characteristics shall be exemplary only.

Preferably, a front side polymeric foil and a rear side polymeric foil may enclose the interposed PV cells and may form a substrate and a superstrate, respectively, prior to performing e.g. the subsequent injection moulding step within the IML procedure. For example, the polymeric foils may have a thickness of between 500µm and 2500µm. Each of the foils may adjoin and/or cover a part or an entirety of one of opposing surfaces of all of the PV cells. The polymeric foils may be made with various polymeric materials such as ethylene vinyl acetate (EVA), polycarbonate (PC), polyethylenterephthalat (PET), polyamide (PA), polyetheretherketone (PEEK) or a mix of them. Particularly, a material forming the polymeric foil may be a thermoplastic material, i.e. a material which becomes plastic or viscous upon being heated to elevated temperatures. The front and rear side polymeric foils may enclose the interposed PV cells and, upon being joined with each other, encapsulate the arrangement of PV cells. Optionally, glass fiber reinforced or carbon fiber reinforced plastics may be included between the polymeric foils.

Particularly, the front side polymeric foil, the rear side polymeric foil and the PV cells may be joined together by an application of heat and/or a lamination process. In other words, after having arranged e.g. the rear side polymeric foil, the PV cells and finally the front side polymeric foil on top of each other in a lose manner in the curvature limited configuration, these stacked layers may be interconnected by mechanically joining with each other. Such joining may be induced for example by applying sufficient heat to the stack such that the polymeric material of the polymeric foils becomes viscous and/or sticky. Accordingly, upon such temporary application of heat, the polymeric foils may mechanically interconnect with each other and/or with the interposed PV cells. Such procedure is sometimes referred to as lamination procedure. As a result of such lamination procedure, the front and rear side polymeric foils and, optionally, also the PV cells are integrally joined with each other in a positive substance jointing. However, the lamination procedure may alternatively or additionally include other measures for joining the polymeric foils such as for example applying a glue or adherent at an interface between the polymeric foils and/or at an interface between one of the polymeric foils and the solar cell arrangement.

The resulting photovoltaic label typically comprises various characteristics. For example, the PV cells included therein are protected at least to a certain degree against mechanical, electrical and/or chemical influences potentially damaging the solar cells. Furthermore, in the laminate forming the photovoltaic label, the PV cells are stabilized and mechanically interconnected with each other via the polymeric foils enclosing the entire solar cell arrangement. Accordingly, the entire photovoltaic label may be easily handled for example during a subsequent PV module fabrication procedure. However, the PV label alone generally does not have sufficient mechanical stability and/or rigidity required by a final PV module. In other words, the photovoltaic label is generally highly bendable at least in areas laterally in between neighbouring solar cells. Particularly, the photovoltaic label alone is generally not self-supporting. Accordingly, the PV label generally has to be provided with a carrier structure for forming a final product forming the PV module.

For example, upon the preparing of the carrier structure, the polymer being in the mouldable condition may be injected into a mould of a moulding tool. Therein, the mould typically comprises a recess. Upon the preparing of the carrier structure, the photovoltaic label may then be arranged in the recess of the mould. In other words, in an injection moulding technique which largely resembles to the in-mould labelling technique, the PV label previously prepared may be precisely arranged at an intended location within the moulding tool. Therein, the PV label may be tightly accommodated within the recess of the moulding tool. Subsequently, the polymer is introduced into the moulding tool, wherein the polymer is brought to its mouldable condition for example by suitably heating the polymer. Polymers which are suitable for such injection moulding may include thermoplastics, thermosets and elastomers. Materials such as polypropylene (PP), polycarbonate (PC), polyethylene (PE), polytetrafluoroethylene (PTFE), polyoxymethylene (POM), acrylonitrile butadiene styrene (ABS), a polyaryletherketone (PAEK), polyether ether ketone (PEEK), copolymers of polypropylene and ethylene, epoxy, phenolic, nylon, polystyrene (PS) and/or silicone (or any combination thereof) may be used for the injection moulded carrier structure. A cavity of the moulding tool defining the final shape of the moulded carrier structure may have any arbitrary shape. Particularly, such cavity may have curved surfaces. Accordingly, the final PV module including the carrier structure and the PV level may have a complex shape and, particularly, may have a shape with non-uniformly curved surfaces corresponding for example to a functional component such as an outer body part of a vehicle.

It shall be noted that possible features and advantages of embodiments of the invention are described herein with respect to a method for fabricating a PV module. One skilled in the art will recognize that the features may be suitably transferred from one embodiment to another and features may be modified, adapted, combined and/or replaced, etc. in order to come to further embodiments of the invention.

### BRIEF DESCRIPTION OF THE DRAWINGS

In the following, advantageous embodiments of the invention will be described with reference to the enclosed drawing. However, neither the drawing nor the description shall be interpreted as limiting the invention.
Fig. 1 shows a perspective view of a PV module forming a mudguard of a car body.
Figs. 2 (a), (b) show a side views onto a PV cell in a planar configuration and in a curved configuration.
Fig. 3 shows a cross-sectional view along the line A-A indicated in Fig. 1.
Fig. 4 visualized arranging PV cells in a curvature limited configuration upon fabricating a curved PV module in accordance with an embodiment of the present invention.
Fig. 5 shows a cross-section through a moulding tool upon fabricating a curved PV module in accordance with an embodiment of the present invention.

The figures are only schematic and not to scale. Same reference signs refer to same or similar features.

### DESCRIPTION OF ADVANTAGEOUS EMBODIMENTS

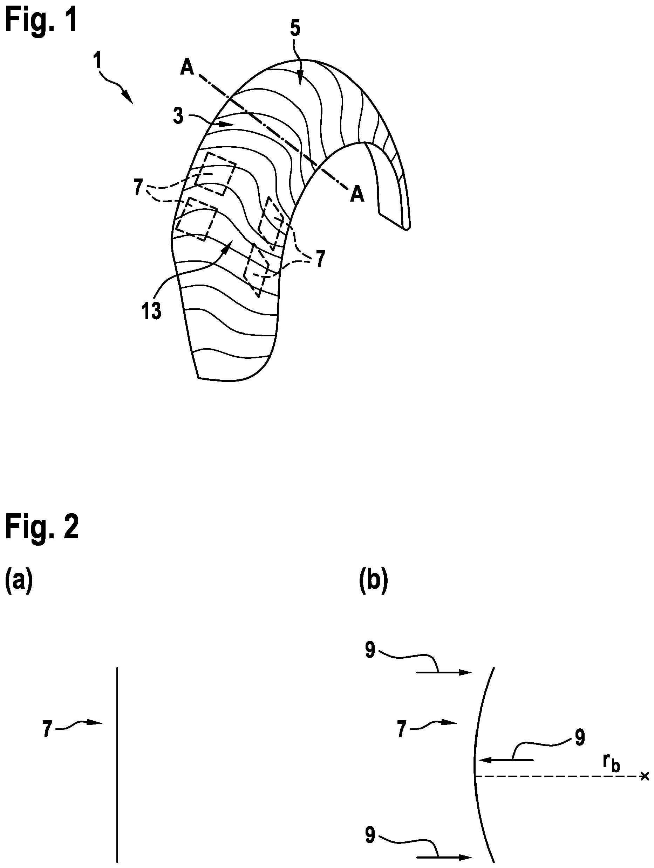

Fig. 1 visualises a contour of a non-uniformly curved PV module 1 forming a body part of a vehicle. In the specific example, the PV module 1 forms a mudguard of a car. Therein, the PV module 1 comprises flat or slightly curved areas 3 as well as significantly curved areas 5. The PV module 1 shall comprise a multiplicity of PV cells 7 (only a few of them being visualised with dotted lines as examples in figure 1). Accordingly, the PV cells 7 are integrally included in the vehicle body part.

Preferably, the PV cells 7 shall be wafer-based silicon PV cells. Such wafer-based PV cells 7 are generally rigid and brittle. With no forces being applied to such PV cells 7, they generally have a plate-like, planar shape as shown in Fig. 2(a).

For fabricating the non-uniformly curved PV module 1, the PV cells 7 have to be included into the PV module 1 in a curved configuration.

Accordingly, in a fabrication method as proposed herein, a minimum allowable bending radius r_{b} of the PV cells 7 has to be determined. For such purpose, bending experiments, bending simulations and/or bending calculations may be performed. Therein, real or virtual bending forces 9, respectively, may be applied to the PV cell 7 in order to bend the PV cell 7. Preferably, such forces 9 are applied in a distributed manner along a lateral extension of the PV cell 7 such that the PV cell 7 bends homogeneously. In the bending experiments, simulations and/or calculations, the minimum allowable bending radius r_{b} is determined to be the radius down to which the PV cell 7 may be bent at a maximum, i.e. just before the PV cell 7 is irreversibly damaged by breaking or cracking.

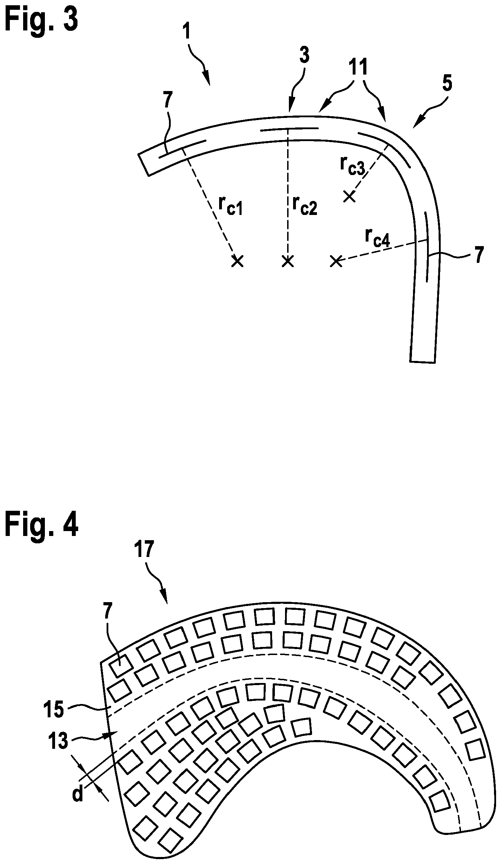

Furthermore, a curvature radius r_{c} of the PV cell 7 upon being included in the PV module 1 has to be analysed, as visualised in Fig. 3. In such analysis, it is assumed that the PV cell 7 is arranged at a positioning area 11 within the PV module 1. Curvature radii r_{c1}, r_{c2}, r_{c3}, r_{c4}, etc. may be analysed for each of multiple positioning areas 11 along the lateral extension of the PV module 1.

For such analysis, arrangement experiments, simulations and/or calculations may be performed. Therein, in an arrangement experiment, a real PV cell 7 may be arranged at a positioning area 11 within or on top of a surface of for example a prototype of a PV module 1 such as to assume a curvature with which the PV cell 7 would be bent upon being included in the non-planar PV module 1 upon completion of the fabrication of such PV module 1. Alternatively, in arrangement simulations or calculations, a virtual PV cell 7 may be virtually arranged at a positioning area 11 within a virtual model of the PV module 1 such as to assume a curvature with which the PV cell 7 would be bent upon being included in the non-planar PV module 1 upon completion of the fabrication of such PV module 1. In the arrangement experiments, simulations and/or calculations, the curvature radii r_{cx} may be measured, simulated or calculated, respectively, for each of various positioning areas 11 within the PV module 1.

As an alternative or additionally to the arrangements experiments, simulations and/or calculations, the curvature radius of the PV cell 7 may be analysed by deformation experiments, deformation simulations and/or deformation calculations. Therein, the PV cell may be arranged at various positioning areas 11 in a similar manner as described above. However, the PV module 1 is not assumed to be in its final geometry, i.e. in a shape which the PV module 1 assumes directly after completion of the fabrication method. Instead, it is assumed that the PV module 1 is deformed into a first temporary geometry while being fabricated. Such deformed geometry may result from forces applied to the PV module 1 and to the PV cells 7 included therein during the fabrication method. Such forces may apply for example during injection moulding for forming a carrier structure for the PV module 1. Upon deformation of the PV module 1 due to such forces, the PV cell 7 being arranged at a positioning area 11 may be bent to a smaller curvature radius r_{c} than it is the case for the PV module 1 being in its final geometry after completion of the fabrication method.

As a further alternative or additionally, expansion experiments, expansion simulations and/or expansion calculations may be used for analysing the curvature radius of the PV cells 7. Therein, the PV module 1 is again assumed to not being in its final geometry but in a geometry resulting upon thermal expansion of the PV module 1 when the PV module 1 is installed in an intended installation configuration and is subjected to predetermined temperature variations.

In the exemplary embodiment described herein, this may mean that the mudguard-shaped PV module 1 is connected to a chassis of a vehicle at various connection positions. Therein, it is then assumed that the PV module 1 may deform due to thermal expansion thereof and the resulting deformations may influence the curvature radius r_{c} of the PV cells 7 included in the PV module 1.

Upon having determined the minimum allowable bending radius r_{b} of the PV cells 7 as well as having analysed the curvature radius r_{c} of the PV cell 7 for each of multiple positioning areas 11 in the PV module 1 in a state as fabricated, during fabrication and/or after installation, the PV cells 7 are then arranged in a curvature limited configuration.

An example of such curvature limited configuration is shown in Fig. 4. Therein, the PV cells 7 are arranged such that none of them overlaps a highly bended area 13 at which the curvature radius r_{c} of the PV cell 7 upon being arranged in such highly bended area 13 would be smaller than the minimum allowable bending radius r_{b}. In other words, the PV cells 7 are arranged in the curvature limited configuration such that all PV cells 7 are completely outside the highly bended area. Accordingly, all PV cells 7 included in the PV module 1 in such curvature limited configuration will have a curvature radius r_{c} > r_{b}. PV cells 7 may be arranged at both opposing sides with regard to the highly bended area 13. As an additional precaution, the PV cells 7 may be arranged at a lateral distance d from the highly bended area 13. As a result of including the PV cells 7 in the PV module 1 in such curvature limited configuration, a risk of breaking or cracking of PV cells 7 is minimised.

In order to arrange the PV cells 7 in the curvature limited configuration and then fix the PV cells 7 in this configuration within the PV module 1, a specific procedure is proposed herein, such procedure resembling to an in-mould labelling procedure. Therein, the PV cells 7 are first arranged on a polymeric foil 15 or, preferably, between two polymeric foils 15. A stack including the one or two polymeric foils 15 and the PV cells 7 may then be laminated to form a PV label 17. In such PV label 17, the PV cells 7 are already fixed in their positions in the curvature limited configuration. However, the PV label 17 is not self-supporting and not stable enough for forming a PV module 1. Accordingly, a carrier structure 29 for carrying the PV label 17 is then prepared.

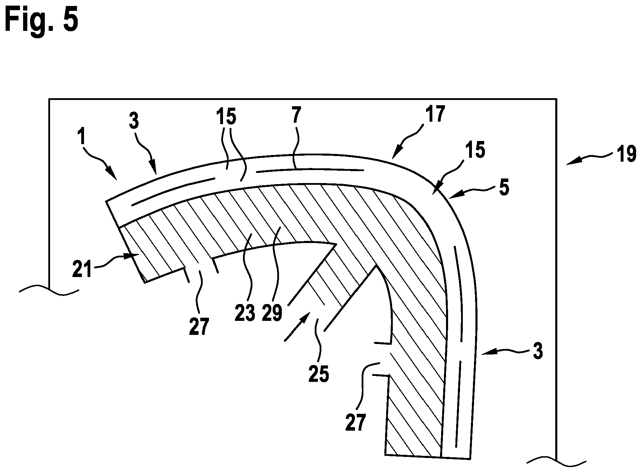

For such purpose, as schematically visualised in Fig. 5, the PV label 17 may be inserted into an injection moulding tool 19. Such tool 19 comprises a cavity 21, at least one inlet 25 to the cavity 21 and at least one outlet 27 from the cavity 21. A shape of the cavity 21 substantially corresponds to an intended geometry of the non-uniformly curved PV module 1. The PV label 17 is preferably arranged at an outer surface defining one side of the cavity 21. Subsequently, a polymer 23 is introduced into the cavity 21. Therein, the polymer 23 is brought to a mouldable condition. For example, the polymer 23 is heated to an elevated temperature being higher than a glass transition temperature of the polymer 23. Accordingly, the polymer 23, upon being introduced through the inlet 25, will distribute throughout the cavity 21 and will contact an exposed surface of the PV label 17. Upon subsequently cooling down the polymer 23, the polymer 23 will solidify and forms the carrier structure 29 while simultaneously forming a positive substance jointing with the polymeric foil 15 of the PV label 17. The final product of such IML-like procedure may be a PV module 1 in which the PV cells 7 are arranged in the curvature limited configuration.

While the PV module 1 may be non-uniformly curved and may include one or more highly bended areas 15, the arrangement of the PV cells 7 is specifically adapted such that PV cells 7 are only included in areas outside such highly bended areas 15. Accordingly, none of the PV cells is excessively bent and breaking or cracking of PV cells 7 prevented.

Finally, it should be noted that the term "comprising" does not exclude other elements or steps and the "a" or "an" does not exclude a plurality. Also elements described in association with different embodiments may be combined. It should also be noted that reference signs in the claims should not be construed as limiting the scope of the claims.

### list of reference numerals:

- 1: PV module
- 3: flat or slightly curved area
- 5: significantly curved area
- 7: PV cell
- 9: bending forces
- 11: positioning area
- 13: highly bended area
- 15: polymeric foil
- 17: PV label
- 19: moulding tool
- 21: cavity
- 23: polymer
- 25: inlet
- 27: outlet
- 29: carrier structure

## Claims

1. Method for fabricating a non-uniformly curved photovoltaic module (1) comprising multiple photovoltaic cells (7), the method at least comprising:
- determining a minimum allowable bending radius r_{b} of the photovoltaic cells (7),
- analysing a curvature radius r_{c} of one of the photovoltaic cells (7) being assumed to being arranged at a positioning area (11) within the photovoltaic module (1), wherein the curvature radius r_{c} is analysed for each of multiple positioning areas (11) along a lateral extension of the photovoltaic module (1),
- arranging the photovoltaic cells (7) in a curvature limited configuration in which none of the photovoltaic cells (7) overlaps a highly bended area (13) the curvature radius r_{c} of which has been analysed to be smaller than the minimum allowable bending radius r_{b} for the photovoltaic cell (7), and
- fixing the photovoltaic cells (7) in the curvature limited configuration within the photovoltaic module (1).

2. Method according to claim 1,
wherein the curvature radius r_{c} is analysed for one of the photovoltaic cells (7) being assumed to being arranged at the positioning area (11) within the photovoltaic module (1) upon the photovoltaic module (1) being in its final geometry after completion of the fabrication method.

3. Method according to claim 2,
wherein the curvature radius r_{c} of the photovoltaic cell (7) is analysed by at least one of arrangement experiments, arrangement simulations and arrangement calculations performed for one of measuring, simulating and calculating, respectively, the curvature radius r_{c} of the photovoltaic cell (7) when being arranged at the positioning area (11).

4. Method according to one of the preceding claims,
wherein the curvature radius r_{c} is analysed for one of the photovoltaic cells (7) being assumed to being arranged at the positioning area (11) within the photovoltaic module (1) upon the photovoltaic module (1) being deformed into a first temporary geometry during the fabrication method.

5. Method according to claim 4,
wherein the curvature radius r_{c} of the photovoltaic cell (7) is analysed by at least one of deformation experiments, deformation simulations and deformation calculations performed for one of measuring, simulating and calculating, respectively, the curvature radius r_{c} of the photovoltaic cell (7) when being arranged at the positioning area (11) upon the photovoltaic cell (7) being subjected to a deformation action, the deformation action occurring as a result of a fabrication procedure and temporarily deforming the curvature of the photovoltaic cell (7) during the fabrication method.

6. Method according to one of the preceding claims,
wherein the curvature radius r_{c} is analysed for one of the photovoltaic cells (7) being assumed to being arranged at the positioning area (11) within the photovoltaic module (1) upon the photovoltaic module (1) being deformed into a second geometry resulting upon thermal expansion of the photovoltaic module (1) upon the fabricated photovoltaic module (1) being installed in an intended installation configuration and being subjected to predefined temperature variations.

7. Method according to claim 6,
wherein the curvature radius r_{c} of the photovoltaic cell (7) is analysed by at least one of expansion experiments, expansion simulations and expansion calculations performed for one of measuring, simulating and calculating, respectively, the curvature radius r_{c} of the photovoltaic cell (7) when being arranged at the positioning area (11) upon the photovoltaic module (1) being subjected to thermal expansion upon the fabricated photovoltaic module (1) being installed in the intended installation configuration and being subjected to predefined temperature variations.

8. Method according to one of the preceding claims,
wherein the minimum allowable bending radius r_{b} of the photovoltaic cell (7) is determined by at least one of bending experiments, bending simulations and bending calculations performed for one of measuring, simulating and calculating, respectively, the curvature radius of the photovoltaic cell upon being successively bent, the minimum allowable bending radius r_{b} being determined as the curvature radius being established just before the photovoltaic cell (7) breaks due to excessive bending.

9. Method according to one of the preceding claims,
wherein the photovoltaic cells (7) are arranged on both opposite sides with regard to the highly bended area (13).

10. Method according to one of the preceding claims,
wherein the photovoltaic cells (7) are arranged at a lateral distance d from the highly bended area (13), the lateral distance d being larger than a predefined minimum distance.

11. Method according to claim 10,
wherein the minimum distance d is predefined in dependence of the curvature radius at the highly bended area.

12. Method according to one of the preceding claims,
wherein the photovoltaic cells (7) included in PV module (1) are wafer-based photovoltaic cells (7).

13. Method according to one of the preceding claims,
wherein the arranging and fixing of the photovoltaic cells (7) include:
- arranging the photovoltaic cells (7) on at least one polymeric foil (15) in the curvature limited configuration,
- fixing the photovoltaic cells (7) on the polymeric foil (15) in the curvature limited configuration thereby forming a photovoltaic label (17), and
- preparing a carrier structure (29) for carrying the photovoltaic label (17), wherein the carrier structure (29) is prepared with a polymer (23) being in a mouldable condition such that the polymer (23) forms a positive substance jointing with the polymeric foil (15) upon solidifying of the polymer (23).

## Patentansprüche

1. Verfahren zum Fertigen eines ungleichmäßig gekrümmten Photovoltaikmoduls (1), das mehrere Photovoltaikzellen (7) umfasst, wobei das Verfahren wenigstens umfasst:
- Bestimmen eines kleinsten zulässigen Biegeradius r_{b} der Photovoltaikzellen (7),
- Analysieren eines Krümmungsradius r_{c} einer der Photovoltaikzellen (7), von der angenommen wird, dass sie in einem Positionierungsbereich (11) innerhalb des Photovoltaikmoduls (1) angeordnet ist, wobei der Krümmungsradius r_{c} für jeden von mehreren Positionierungsbereichen (11) entlang einer seitlichen Erstreckung des Photovoltaikmoduls (1) analysiert wird,
- Anordnen der Photovoltaikzellen (7) in einer krümmungsbegrenzten Konfiguration, in der keine der Photovoltaikzellen (7) einen stark gebogenen Bereich (13) überlappt, dessen Krümmungsradius r_{c} als kleiner als der kleinste zulässige Biegeradius r_{b} für die Photovoltaikzelle (7) analysiert wurde, und
- Fixieren der Photovoltaikzellen (7) in der krümmungsbegrenzten Konfiguration innerhalb des Photovoltaikmoduls (1).

2. Verfahren nach Anspruch 1,
wobei der Krümmungsradius r_{c} für eine der Photovoltaikzellen (7) analysiert wird, von der angenommen wird, dass sie in dem Positionierungsbereich (11) innerhalb des Photovoltaikmoduls (1) angeordnet ist, nachdem sich das Photovoltaikmodul (1) nach Vollendung des Fertigungsverfahrens in seiner endgültigen Geometrie befindet.

3. Verfahren nach Anspruch 2,
wobei der Krümmungsradius r_{c} der Photovoltaikzelle (7) durch wenigstens eines von Anordnungsexperimenten, Anordnungssimulationen und Anordnungsberechnungen analysiert wird, die zum Messen, Simulieren bzw. Berechnen des Krümmungsradius r_{c} der Photovoltaikzelle (7) durchgeführt werden, wenn sie in dem Positionierungsbereich (11) angeordnet ist.

4. Verfahren nach einem der vorangehenden Ansprüche,
wobei der Krümmungsradius r_{c} für eine der Photovoltaikzellen (7) analysiert wird, von der angenommen wird, dass sie in dem Positionierungsbereich (11) innerhalb des Photovoltaikmoduls (1) angeordnet ist, nachdem das Photovoltaikmodul (1) während des Fertigungsverfahrens in eine erste temporäre Geometrie verformt wurde.

5. Verfahren nach Anspruch 4,
wobei der Krümmungsradius r_{c} der Photovoltaikzelle (7) durch wenigstens eines von Verformungsexperimenten, Verformungssimulationen und Verformungsberechnungen analysiert wird, die zum Messen, Simulieren bzw. Berechnen des Krümmungsradius r_{c} der Photovoltaikzelle (7) durchgeführt werden, wenn sie in dem Positionierungsbereich (11) angeordnet ist, nachdem die Photovoltaikzelle (7) einer Verformungswirkung ausgesetzt wurde, wobei die Verformungswirkung im Ergebnis einer Fertigungsoperation stattfindet und die Krümmung der Photovoltaikzelle (7) während des Fertigungsverfahrens vorübergehend verformt.

6. Verfahren nach einem der vorangehenden Ansprüche,
wobei der Krümmungsradius r_{c} für eine der Photovoltaikzellen (7) analysiert wird, von der angenommen wird, dass sie in dem Positionierungsbereich (11) innerhalb des Photovoltaikmoduls (1) angeordnet ist, nachdem das Photovoltaikmodul (1) zu einer zweiten Geometrie verformt wurde, die aus einer Wärmeausdehnung des Photovoltaikmoduls (1) resultiert, nachdem das gefertigte Photovoltaikmodul (1) in einer beabsichtigten Installationskonfiguration installiert und vordefinierten Temperaturveränderungen ausgesetzt wurde.

7. Verfahren nach Anspruch 6,
wobei der Krümmungsradius r_{c} der Photovoltaikzelle (7) durch wenigstens eines von Ausdehnungsexperimenten, Ausdehnungssimulationen und Ausdehnungsberechnungen analysiert wird, die zum Messen, Simulieren bzw Berechnen des Krümmungsradius r_{c} der Photovoltaikzelle (7) durchgeführt werden, wenn sie in dem Positionierungsbereich (11) angeordnet ist, nachdem die Photovoltaikzelle (7) einer Wärmeausdehnung ausgesetzt wurde, nachdem das gefertigte Photovoltaikmodul (1) in einer beabsichtigten Installationskonfiguration installiert und vordefinierten Temperaturveränderungen ausgesetzt wurde.

8. Verfahren nach einem der vorangehenden Ansprüche,
wobei der kleinste zulässige Biegeradius r_{b} der Photovoltaikzelle (7) durch wenigstens eines von Biegeexperimenten, Biegesimulationen und Biegeberechnungen bestimmt wird, die zum Messen, Simulieren bzw. Berechnen des Krümmungsradius der Photovoltaikzelle durchgeführt werden, nachdem sie sukzessive gebogen wurde, wobei der kleinste zulässige Biegeradius r_{b} als der Krümmungsradius bestimmt wird, der festgestellt wird, kurz bevor die Photovoltaikzelle (7) aufgrund übermäßigen Biegens bricht.

9. Verfahren nach einem der vorangehenden Ansprüche,
wobei die Photovoltaikzellen (7) auf beiden gegenüberliegenden Seiten in Bezug auf den stark gebogenen Bereich (13) angeordnet sind.

10. Verfahren nach einem der vorangehenden Ansprüche,
wobei die Photovoltaikzellen (7) in einer seitlichen Entfernung d von der stark gebogenen Fläche (13) angeordnet sind, wobei die seitliche Entfernung d größer ist als eine vordefinierte Mindestentfernung.

11. Verfahren nach Anspruch 10,
wobei die Mindestentfernung d in Abhängigkeit vom Krümmungsradius an dem stark gebogenen Bereich vordefiniert wird.

12. Verfahren nach einem der vorangehenden Ansprüche,
wobei die in dem Photovoltaikmodul (1) enthaltenen Photovoltaikzellen (7) Photovoltaikzellen (7) auf Waferbasis sind.

13. Verfahren nach einem der vorangehenden Ansprüche,
wobei das Anordnen und Fixieren der Photovoltaikzellen (7) umfasst:
- Anordnen der Photovoltaikzellen (7) auf wenigstens einer Polymerfolie (15) in der krümmungsbegrenzten Konfiguration,
- Fixieren der Photovoltaikzellen (7) auf der Polymerfolie (15) in der krümmungsbegrenzten Konfiguration, wodurch ein Photovoltaik-Label (17) gebildet wird, und
- Ausbilden einer Trägerstruktur (29) zum Tragen des Photovoltaik-Labels (17), wobei die Trägerstruktur (29) mit einem Polymer (23) ausgebildet wird, das sich in einem formbaren Zustand befindet, dergestalt, dass das Polymer (23) beim Verfestigen des Polymers (23) eine stoffschlüssige Verbindung mit der Polymerfolie (15) bildet.

## Revendications

1. Procédé de fabrication d'un module photovoltaïque (1) non uniformément courbé comprenant plusieurs cellules photovoltaïques (7), le procédé comprenant au moins de :
- déterminer un rayon de courbure minimal admissible r_{b} des cellules photovoltaïques (7),
- analyser un rayon de courbure r_{c} de l'une des cellules photovoltaïques (7) supposée être disposée sur une zone de positionnement (11) à l'intérieur du module photovoltaïque (1), le rayon de courbure r_{c} étant analysé pour chacune de plusieurs zones de positionnement (11) le long d'une extension latérale du module photovoltaïque (1),
- disposer les cellules photovoltaïques (7) dans une configuration à courbure limitée dans lequel aucune des cellules photovoltaïques (7) ne chevauche une zone fortement courbée (13) dont le rayon de courbure r_{c} a été analysé pour être inférieur au rayon de courbure minimal admissible r_{b} pour la cellule photovoltaïque (7), et
- fixer les cellules photovoltaïques (7) dans la configuration à courbure limitée à l'intérieur du module photovoltaïque (1).

2. Procédé selon la revendication 1,
dans lequel le rayon de courbure r_{c} est analysé pour l'une des cellules photovoltaïques (7) supposée être disposée sur la zone de positionnement (11) à l'intérieur du module photovoltaïque (1) lorsque le module photovoltaïque (1) est dans sa géométrie finale après achèvement du procédé de fabrication.

3. Procédé selon la revendication 2,
dans lequel le rayon de courbure r_{c} de la cellule photovoltaïque (7) est analysé par des expériences de disposition, des simulations de disposition et/ou des calculs de disposition effectués pour, respectivement, mesurer, simuler et/ou calculer le rayon de courbure r_{c} de la cellule photovoltaïque (7) lorsqu'elle est disposée sur la zone de positionnement (11).

4. Procédé selon l'une des revendications précédentes,
dans lequel le rayon de courbure r_{c} est analysé pour l'une des cellules photovoltaïques (7) supposée être disposée sur la zone de positionnement (11) à l'intérieur du module photovoltaïque (1) lorsque le module photovoltaïque (1) est déformé dans une première géométrie temporaire pendant le procédé de fabrication.

5. Procédé selon la revendication 4,
dans lequel le rayon de courbure r_{c} de la cellule photovoltaïque (7) est analysé par des expériences de déformation, des simulations de déformation et/ou des calculs de déformation effectués pour, respectivement, mesurer, simuler et/ou calculer le rayon de courbure r_{c} de la cellule photovoltaïque (7) lorsqu'elle est disposée sur la zone de positionnement (11) et que la cellule photovoltaïque (7) est soumise à une action de déformation, l'action de déformation se produisant comme résultat d'une procédure de fabrication et déformant temporairement la courbure de la cellule photovoltaïque (7) pendant le procédé de fabrication.

6. Procédé selon l'une des revendications précédentes,
dans lequel le rayon de courbure r_{c} est analysé pour l'une des cellules photovoltaïques (7) supposée être disposée sur la zone de positionnement (11) à l'intérieur du module photovoltaïque (1) lorsque le module photovoltaïque (1) est déformé dans une seconde géométrie résultant de la dilatation thermique du module photovoltaïque (1) lorsque le module photovoltaïque fabriqué (1) est installé dans une configuration d'installation prévue et est soumis à des variations de température prédéfinies.

7. Procédé selon la revendication 6,
dans lequel le rayon de courbure r_{c} de la cellule photovoltaïque (7) est analysé par des expériences de dilatation, des simulations de dilatation et/ou des calculs de dilatation effectués pour, respectivement, mesurer, simuler et/ou calculer le rayon de courbure r_{c} de la cellule photovoltaïque (7) lorsqu'elle est disposée sur la zone de positionnement (11) et que le module photovoltaïque (1) est soumis à une dilatation thermique lorsque le module photovoltaïque fabriqué (1) est installé dans la configuration d'installation prévue et est soumis à des variations de température prédéfinies.

8. Procédé selon l'une des revendications précédentes,
dans lequel le rayon de courbure minimal admissible r_{b} de la cellule photovoltaïque (7) est déterminé par des expériences de courbure, des simulations de courbure et/ou des calculs de courbure effectués pour, respectivement, mesurer, simuler et/ou calculer le rayon de courbure de la cellule photovoltaïque lors de courbures successives, le rayon de courbure minimal admissible r_{b} étant déterminé comme le rayon de courbure établi juste avant que la cellule photovoltaïque (7) ne se brise en raison d'une courbure excessive.

9. Procédé selon l'une des revendications précédentes,
dans lequel les cellules photovoltaïques (7) sont disposées sur les deux côtés opposés par rapport à la zone fortement courbée (13).

10. Procédé selon l'une des revendications précédentes,
dans lequel les cellules photovoltaïques (7) sont disposées à une distance latérale d de la zone fortement courbée (13), la distance latérale d étant supérieure à une distance minimale prédéfinie.

11. Procédé selon la revendication 10,
dans lequel la distance minimale d est prédéfinie en fonction du rayon de courbure de la zone fortement courbée.

12. Méthode selon l'une des revendications précédentes,
dans lequel les cellules photovoltaïques (7) incluses dans le module PV (1) sont des cellules photovoltaïques (7) à base de wafers.

13. Procédé selon l'une des revendications précédentes, dans lequel la disposition et la fixation des cellules photovoltaïques (7) comprennent de :
- disposer les cellules photovoltaïques (7) sur au moins une feuille polymère (15) dans la configuration à courbure limitée,
- fixer les cellules photovoltaïques (7) sur la feuille polymère (15) dans la configuration à courbure limitée, formant ainsi une étiquette photovoltaïque (17), et
- préparer une structure porteuse (29) pour porter l'étiquette photovoltaïque (17), la structure porteuse (29) étant préparée avec un polymère (23) dans un état moulable de sorte que le polymère (23) forme une liaison par matière avec le film polymère (15) lors de la solidification du polymère (23).
